# EUROPEAN PATENT SPECIFICATION

(11) **EP 3 559 308 B1**
(45) Date of publication and mention of the grant of the patent: **01.07.2026**
(21) Application number: 17817767.1
(22) Date of filing: 21.12.2017
(51) Int. Cl.: C23C 16/455, C23C 16/40

(54) **METHOD FOR DEPOSITING ALUMINA BY ATOMIC LAYER DEPOSITION**
VERFAHREN ZUR ABSCHEIDUNG VON ALUMINIUMOXID DURCH ATOMSCHICHTABSCHEIDUNG
PROCÉDÉ DE DÉPÔT D'ALUMINE PAR DÉPÔT DE COUCHE ATOMIQUE

(30) Priority: 21.12.2016 LU 93390
(43) Date of publication of application: 30.10.2019
(73) Proprietor: LUXEMBOURG INSTITUTE OF SCIENCE AND TECHNOLOGY (LIST), 4362 Esch-sur-Alzette (LU)
(72) Inventor: LETURCQ, Renaud, 2518 Luxembourg (LU); ADJEROUD, Noureddine, 1939 Luxembourg (LU); WACK, Sabrina, 57440 Angevillers (FR)
(74) Representative: Ipsilon Luxembourg
(86) International application number: PCT/EP2017/084244
(87) International publication number: WO 2018/115369

(56) References cited:
- CN-A- 104 152 868
- US-A1- 2009 079 328
- US-A1- 2011 076 513
- ELAM J W ET AL: "Properties of ZnO/Al2O3 alloy films grown using atomic layer deposition techniques", JOURNAL OF THE ELECTROCHEMICAL SOCIETY, ELECTROCHEMICAL SOCIETY, vol. 150, no. 6, 1 June 2003 (2003-06-01), pages G339 - G347, XP002594705, ISSN: 0013-4651, [retrieved on 20030411], DOI: 10.1149/1.1569481
- NAMJUN KIM ET AL: "The structure of ion beam sputtered amorphous alumina films and effects of Zn doping: High-resolution 27 Al NMR", JOURNAL OF NON-CRYSTALLINE SOLIDS., vol. 405, 3 September 2014 (2014-09-03), NL, pages 1 - 6, XP055453350, ISSN: 0022-3093, DOI: 10.1016/j.jnoncrysol.2014.08.022
- YUAN WANG ET AL: "Enhanced Dielectric Properties and High-Temperature Microwave Absorption Performance of Zn-Doped Al2O3 Ceramic", JOURNAL OF ELECTRONIC MATERIALS., vol. 44, no. 7, 22 April 2015 (2015-04-22), US, pages 2353 - 2358, XP055453322, ISSN: 0361-5235, DOI: 10.1007/s11664-015-3787-4

## Description

### Technical field

The invention is directed to atomic layer deposition of thin films or layers of alumina on a substrate.

### Background art

Atomic Layer Deposition (ALD) is a method used to deposit thin film. Thin films or layers comprising alumina are particularly interesting for their physical properties such as optical and dielectric properties and are used for many applications, such as gas permeation barrier, gate dielectric, optical layer or protective transparent and insulating layer.

The Al₂O₃ Atomic Layer Deposition (ALD) is usually performed at high temperatures, such as 80° C or more, in order to grow layers or films of high qualities. However, Al₂O₃ grown with Atomic Layer Deposition at high temperature is not adapted for certain applications particularly with materials having different thermal expansion coefficients and with materials sensitive to temperature such as organic or biological samples.

Prior art published scientific paper M.D. Groner and al. Chem.Mater. 2004, 16, 639-645 discloses a method for depositing a film of Al₂O₃ by the technique of Atomic Layer Deposition (ALD) on a thermally sensitive substrate. The method is performed at temperatures as low as 33°C and comprises using alternating exposures of trimethylaluminum (Al(CH₃)₃; TMA) and H₂O. Al₂O₃ Atomic Layer Deposition has been performed at temperatures from 33 to 177° C. The results obtained at high temperatures are better than those obtained with lower temperatures. The layer obtained at 33° C shows a low density and one ALD cycle requires a time up to 200 seconds for the same temperature. This method shows limitations for forming an Al₂O₃ layer at low or ambient temperatures.

Prior art published scientific paper M.D.Groner and al. Thin Solid Films. 2002, 413, 186 - 197 also discloses a method for forming Al₂O₃ on a substrate by the technique of Atomic Layer Deposition (ALD). The method uses alternating exposures of trimethylaluminum (Al(CH₃)₃; TMA) and H₂O. Al₂O₃ Atomic Layer Deposition has been performed at high temperatures, up to 177°C. The method is not adapted to form Al₂O₃ layer on thermal sensitive substrates.

Prior art published scientific paper K.-H Choi and al., « Characterization of Al2O3 Thin Films Fabricated at Low Temperature via Atomic Layer Deposition on PEN Substrates », Chemical Vapor Deposition, 2014, 20, 118-124 discloses a method for depositing a film of Al₂O₃ by the technique of Atomic Layer Deposition (ALD) on a PEN substrate. The method is performed at low and high temperatures. The results obtained at high temperatures are better than those obtained at low temperatures.

The document CN104152868A discloses an ALD method for obtaining an aluminium oxide layer with zinc, according to the preamble of claim 1.

US patent application 2011/076513A1 discloses an ALD method comprising the steps of exposing a substrate to a mixture of TMA and diethyl zinc (DEZ) precursors, followed by exposing the substrate to an oxidant in order to deposit a layer of aluminium oxide with zinc, according to the preamble of claim 1. Also disclosed is layer of ZnO doped with Al.

US patent application 2009/079328A1 also discloses an ALD method comprising the steps of exposing a substrate to a mixture of TMA and DEZ precursors, followed by exposing the substrate to an oxidant in order to deposit a layer of aluminium oxide with zinc. The temperature is advantageously of 110°C.

The publication from Namjun Kim et al., "The structure of ion beam sputtered amorphous alumina films and effects on Zn doping: High-resolution 27AI NMR", Journal of Non-crystalline Solids, vol. 405, 3 september 2014 (2014-09-03), pp.1-6 discloses the formation of a layer of alumina doped with Zn via ion beam sputtering, said layer is 500 nm thick.

The scientific paper of Yuan Wang et al., "Enhanced dielectric properties and High-temperature microwave absorption performance of Zn-doped Al2O3 ceramic", Journal of Electronic Materials, Vol.44, n°7, 22 april 2015, pp.2353-2358, relates to the production of Zn-doped Al2O3 ceramic, Zn being present as Zn2+, by a ceramic conventional method, wherein the layer is of 2 mm - 3 mm and the sintering temperature is 1823K.

### Summary of invention

### Technical Problem

The invention has for technical problem to provide a solution to at least one shortcoming of the mentioned prior art. More particularly, the invention has for technical problem to provide a method for depositing a high-quality layer of alumina on a substrate by atomic layer deposition (ALD). The invention has also for technical problem to provide a method of depositing by ALD a high-quality alumina layer on substrates which are thermally sensitive or non-thermally sensitive. The invention has also for technical problem to provide a time and cost effective solution.

### Technical solution

The first object of the invention is directed to a method for forming aluminium oxide on a substrate, said method comprising providing the substrate into a reaction chamber and performing at least one atomic layer deposition cycle, each cycle comprising the sequential steps of exposing the substrate to a trimethylaluminium precursor into the reaction chamber and exposing the substrate to an oxidant into the reaction chamber; remarkable in that the method further comprises a step of exposing the substrate to a diethylzinc precursor before the step or at least one of the steps of exposing the substrate to the trimethylaluminum precursor, and in that said method is performed at a temperature between 20°C and 60°C.

According to a preferred embodiment, the oxidant is H₂O.

According to a preferred embodiment, the step of exposing the substrate to the diethylzinc precursor takes place before each of the steps of exposing the substrate to the trimethylaluminum precursor.

According to a preferred embodiment, the step of exposing the substrate to the diethylzinc precursor takes place before the first one of the steps of exposing the substrate to the trimethylaluminum precursor.

According to a preferred embodiment, at least one, preferably each, of the steps of exposing the substrate to the diethylzinc precursor, the trimethylaluminum precursor and to the oxidant is followed by a step of purging the reaction chamber in order to remove the excess of the diethylzinc precursor, the trimethylaluminium precursor and/or the oxidant.

According to a preferred embodiment, each step of exposing the substrate to the diethylzinc precursor and the trimethylaluminum precursor is performed with a carrier gas, said gas preferably being nitrogen or argon.

According to a preferred embodiment, said method is performed at a pressure which is comprised between 0 and 1000 mbar, preferably between 1 and 5 mbar.

According to a preferred embodiment, the duration of each step of exposing the substrate to the diethylzinc precursor, the trimethylaluminum precursor and to the oxidant is comprised between 1µs to 60s, preferably between 1ms and 60s.

According to a preferred embodiment, the duration of each step of purge is comprised between 0s to 600s.

According to a preferred embodiment, the thickness of the layer increases approximately until 134 nm when the method is performed at 20°C in the presence of water.

The second object of the invention is directed to a product according to claim 11.

Further developments of the invention are according to dependent claims 12-14.

### Advantages of the invention

The invention is particularly interesting in that the method of ALD of depositing a film or layer comprising alumina can be used to coat thermally sensitive substrates as well as non-thermally sensitive substrates. The layer obtained with this method is a conformal layer of alumina of high quality which presents a high density and good properties such as optical and dielectric properties. The method has shown better results and shorter ALD cycle time compared to literature method. The invention has also the advantage of decreasing deposition cost for non-thermally sensitive substrates due to the decrease or absence of heating.

### Brief description of the drawings

Figure 1: Flowchart for an exemplary embodiment of alumina ALD deposition method.
Figure 2: Comparison of the thickness of layers grown with a TMA-H₂O ALD method (literature method) versus layers grown with a DEZ-TMA-H₂O ALD method.
Figure 3: Comparison of the relaxation time after H₂O pulse for the TMA-H₂O ALD method (literature method), DEZ-H₂O ALD method and DEZ-TMA-H₂O ALD method at two temperatures.
Figure 4: XPS analysis of the stoichiometry of a ZnO and a Al₂O₃ layers grown with an ALD literature method performed at 100°C and layers grown with the DEZ-TMA-H₂O ALD method at different temperatures.
Figure 5a: XPS analysis of the environment of Zn.
Figure 5b: XPS spectrum of the environment of Zn.
Figure 5c: XPS spectrum of the environment of Zn.
Figure 5d: XPS spectrum and analysis of the environment of Zn.
Figure 6a: SIMS analysis of the ratio Zn/Al in the layers grown with a DEZ-TMA-H₂O ALD method at different temperatures.
Figure 6b: SIMS analysis of the ratio C/Al in the layers grown with a DEZ-TMA-H₂O ALD method at different temperatures.
Figure 6c: SIMS analysis of the ratio H/Al in the layers grown with a DEZ-TMA-H₂O ALD method at different temperatures.
Figure 7: EDX spectrum of Zn across the layer grown with a DEZ-TMA-H₂O ALD method at 20° C.
Figure 8: XRD spectrum of the layer grown with a DEZ-TMA-H₂O ALD method at 20° C.
Figure 9: Helium transmission rate measured for different samples: aluminium film of thickness 200 µm (for evaluating the base-line of the setup of the present invention), aluminium oxide film (80 nm) deposited on PET (250 µm thick) at 20°C following the ALD method (DEZ-TMA-H₂O) according to the invention, alumina film (15 nm thick) deposited at 80°C on PET (250 µm thick) with the literature ALD method (TMA-H₂O), and PET film of thickness 250 µm.

### Description of an embodiment

In the following description, the term "thermally sensitive" refers to a substrate or any sample composed of different sub-elements, whose physical or chemical properties change as a function of the temperature in an irreversible way within the temperature range 0°C to 120°C.

The invention is about a method for depositing of a high-quality layer comprising alumina, on a substrate, by atomic layer deposition (ALD). Atomic layer deposition is a method used to deposit thin and conformal layer on a substrate. Atomic layer deposition is based on sequential, self-limiting and surface-controlled gas phase chemical reactions to achieve control of layer or film growth. The method of atomic layer deposition comprises steps of passing a substrate into a reaction chamber and exposing said substrate to chemical precursors in order to grow a film or a layer on the substrate.

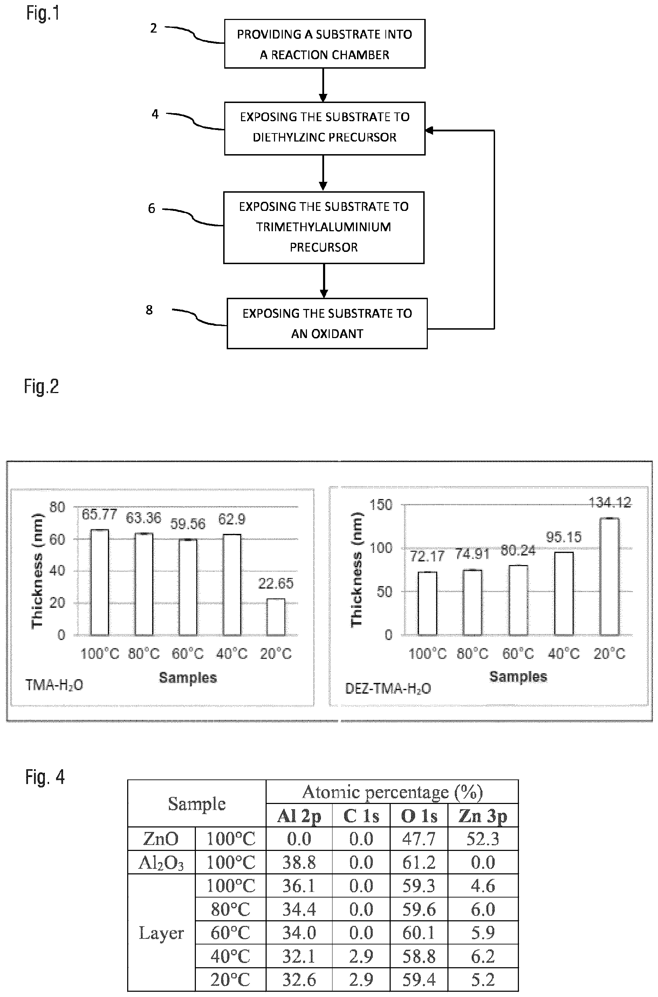

The formation of alumina on a substrate (Figure 1) was performed by a step 2 of providing the substrate into the reaction chamber and performing at least one cycle of atomic layer deposition. The precursors used are diethylzinc (DEZ) and trimethylaluminium (TMA). Each cycle of ALD comprises the sequential steps 4, 6 and 8 of exposing the substrate to a diethylzinc (Zn(C₂H₅)₂) precursor into the reaction chamber, exposing the substrate to a trimethylaluminium (Al(CH₃)₃) precursor into the reaction chamber and exposing the substrate to an oxidant into the reaction chamber. The step 4 of exposing the substrate to a diethylzinc precursor takes place before the step 6 or at least one of the steps 6 of exposing the substrate to the trimethylaluminum precursor. Preferably, the step 4 of exposing the substrate to a diethylzinc precursor takes place before each of the steps 6 of exposing the substrate to the trimethylaluminum precursor. More preferably, the step 4 of exposing the substrate to the diethylzinc precursor takes place before the first one of the steps 6 of exposing the substrate to the trimethylaluminum precursor. Each step 4 and 6 of exposing the substrate to the diethylzinc precursor and the trimethylaluminum precursor can be performed with a carrier gas, said gas preferably being nitrogen or argon. The method is performed at a temperature which is comprised between 20°C and 60°C and can be at a pressure which is comprised between 0 and 1000 mbar, preferably comprised between 1 and 5 mbar. The ALD cycle or each ALD cycle can be performed with a temporal ALD process or with a spatial ALD process. These methods are well-known by the skilled person.

At least one, preferably each, of the steps 4, 6 and 8 of exposing the substrate to the diethylzinc precursor, the trimethylaluminum precursor and the oxidant can be followed by a step of purging the reaction chamber in order to remove the excess of the diethylzinc precursor, the trimethylaluminium precursor and/or the oxidant. The goal of this step of purging or removing the excess of the diethylzinc precursor, the trimethylaluminium precursor and/or the oxidant is to avoid the presence of more than one precursor in the gas phase in contact with the substrate at a given time. The step of purging can be performed either by evacuating the chamber by pumping or by letting pass a purge gas, but any other method of removing the precursor in the gas phase, such as spatial separation, can be used. These previous purging methods in ALD are well-known by a skilled person in the art. More particularly, the duration of each step 4, 6 and 8 of exposing the substrate to the diethylzinc precursor, the trimethylaluminum precursor and the oxidant can be comprised between 1µs to 60s. The duration of each step of purge can be comprised between 0 to 600s. The oxidant used is H₂O but other oxidants can be used such as O₂, O₃, H₂O₂, NO₂, N₂O₄. Due to the range of temperatures, the substrate can be made of glass or Si, or PET (Polyethylene terephthalate) for example or it can be any thermally sensitive substrates such as, but not limited to, organic, biological or polymeric substrates, coated or functionalized with other materials, homogeneously deposited or patterned, and/or materials with different thermal expansion coefficients. After the at least one ALD cycle, the substrate is removed from the reaction chamber.

A TMA-H₂O ALD method known in the literature and a DEZ-TMA-H₂O ALD method according to the invention were performed on a substrate of silicium, glass and PET in order to deposit alumina on the substrate. Both methods were performed at temperatures comprised between 20° C and 100°C. The thickness of each sample was measured in Figure 2 by ellipsometry and fitted with a Al₂O₃ Cauchy Model. The thickness of the sample significantly decreases at 20° C when the layer of alumina is formed with a TMA-H₂O ALD method as disclosed in K.-H. Choi and al., "Characterization of Al2O3 Thin Films Fabricated at Low Temperature via Atomic Layer Deposition on PEN Substrates". Chemical Vapor Deposition, 2014, 20, 118-124. The thickness of the sample at 20°C increases approximatively until 134 nm when the layer is formed with the DEZ-TMA-H₂O ALD method. The decrease of thickness observed with the TMA-H₂O ALD method is not observed with the DEZ-TMA-H₂O ALD method.

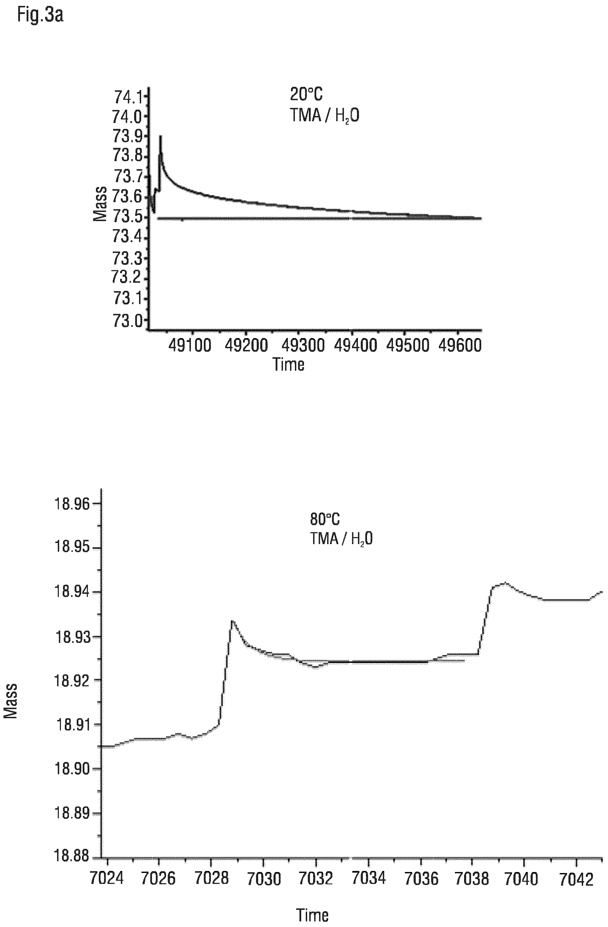

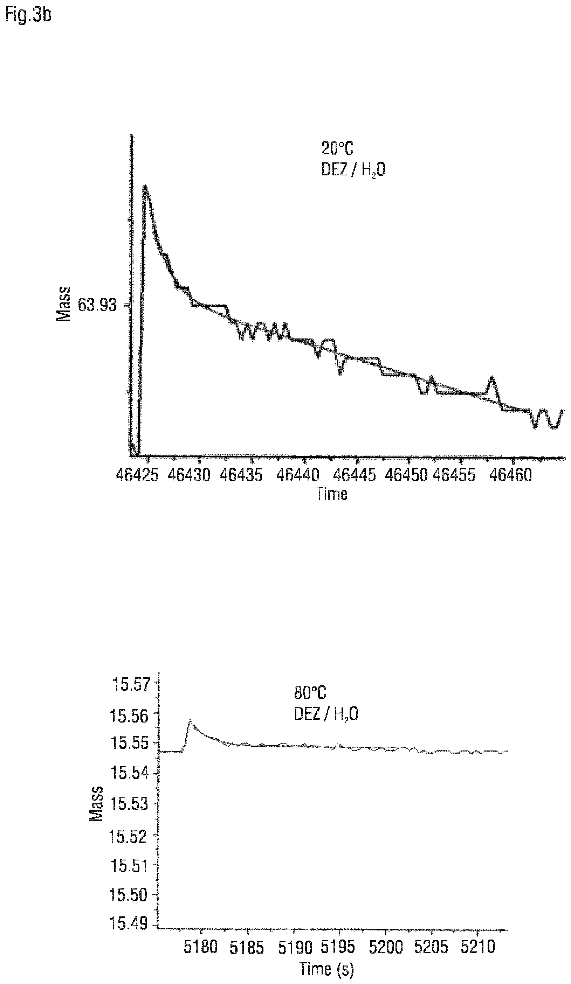

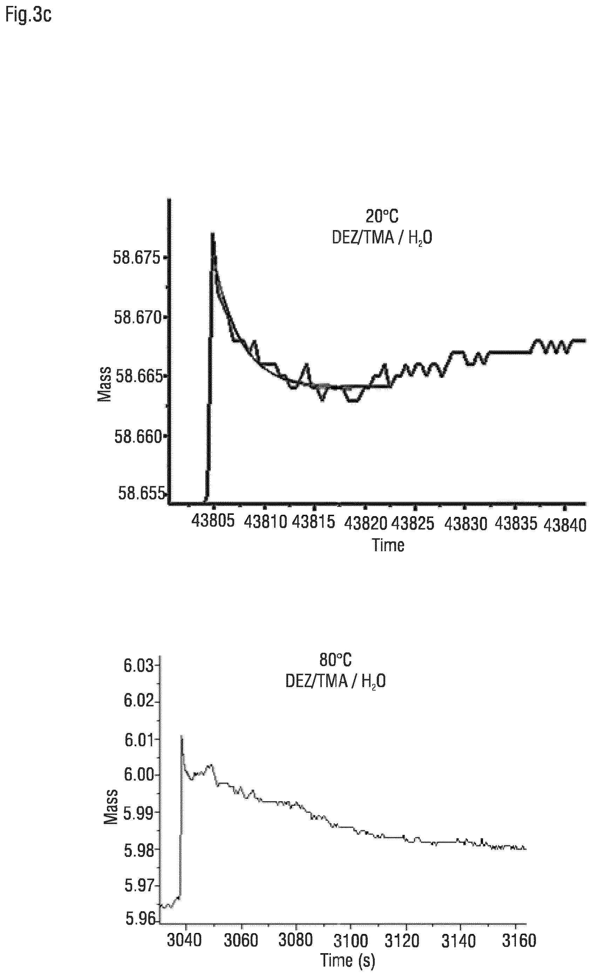

A quartz crystal microbalance (QCM) measurement was performed in order to compare the relaxation time after an H₂O pulse in a TMA-H₂O ALD method, a DEZ-H₂O ALD method and a DEZ-TMA-H₂O ALD method, at two different temperatures. The results are represented in figure 3 and show, for the TMA-H₂O ALD method, a slow relaxation time at 20°C and a fast relaxation time at 80°C. Fast relaxation times are observed for the DEZ-H₂O ALD method and the DEZ-TMA-H₂O ALD method at the two temperatures. The results demonstrate a high dependence of the temperature on the relaxation time for the TMA-H₂O ALD method and a low dependence of the temperature on the relaxation time for the DEZ-TMA-H₂O ALD method. The DEZ-TMA-H₂O ALD method is able to overcome the limitation meets in the TMA-H₂O ALD method at low temperature.

The results of the X-Ray Photoelectron Spectroscopy (XPS) analysis (Figure 4) show the chemical composition of the layer obtained with the DEZ-TMA-H₂O ALD method at temperatures comprised between 20° and 100°C. The results show that the layer obtained at 20°C comprises Zn_{X}Al₂₋ₓO₃ with x inferior to 1. Preferably, x is comprised between 0.03 and 0.07, more preferably x=0.05. The layer comprises at least 90% of Zn_{X}Al₂₋ₓO₃.This analysis shows that the layer is a Zn-doped Al₂O₃ layer with a small incorporation of Zn. The step with DEZ in the ALD process of the invention is believed to prepare the further reaction with TMA and the oxidant, by avoiding accumulation of non-reacting precursors occurring at low temperature in the usual TMA-H₂O ALD method.

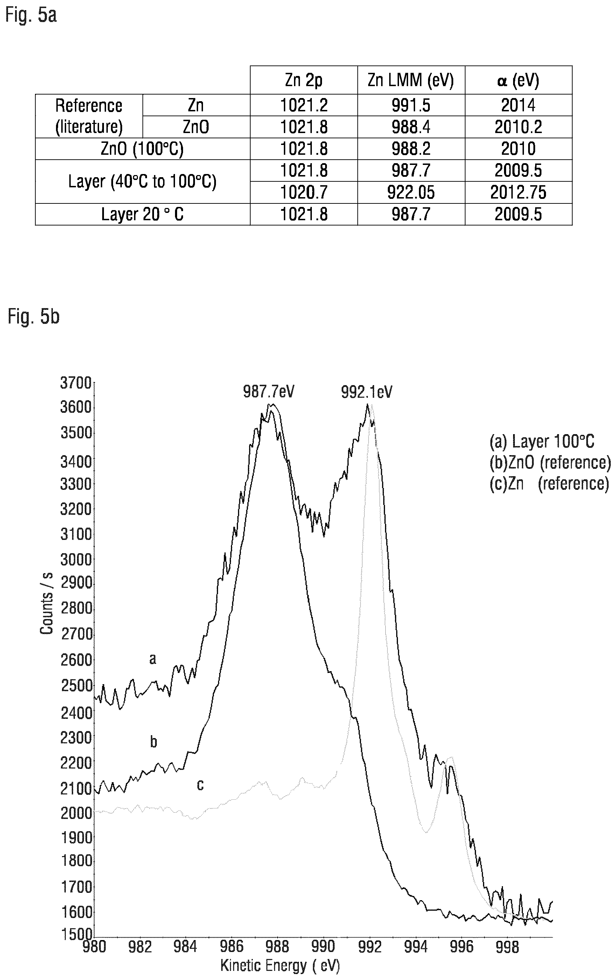

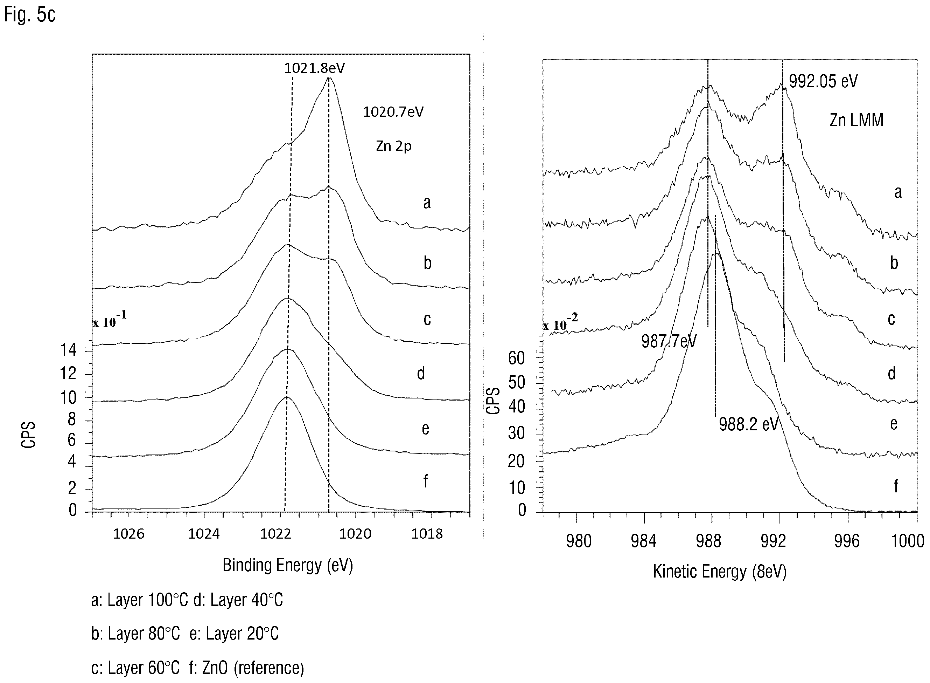

A XPS analysis of the environment of Zn was performed and the results are shown in figures 5a to 5c. The spectrum of Zn 2p shows that in layers grown at low temperature (20°C) with the DEZ-TMA-H₂O ALD method, Zn content appears in the XPS spectrum as Zn⁺² This result corresponds to the degree of oxidation of Zn in zinc oxide (ZnO), but the stoichiometry is not the one of ZnO. For layers obtained with the same method at higher temperatures (40°C to 100°C), Zn is appearing as Zn⁺² and Zn⁰.

The spectrum of Zn LMM reveals the presence of a peak to lower energy for layers grown with the DEZ-TMA-H₂O compared to pure ZnO.

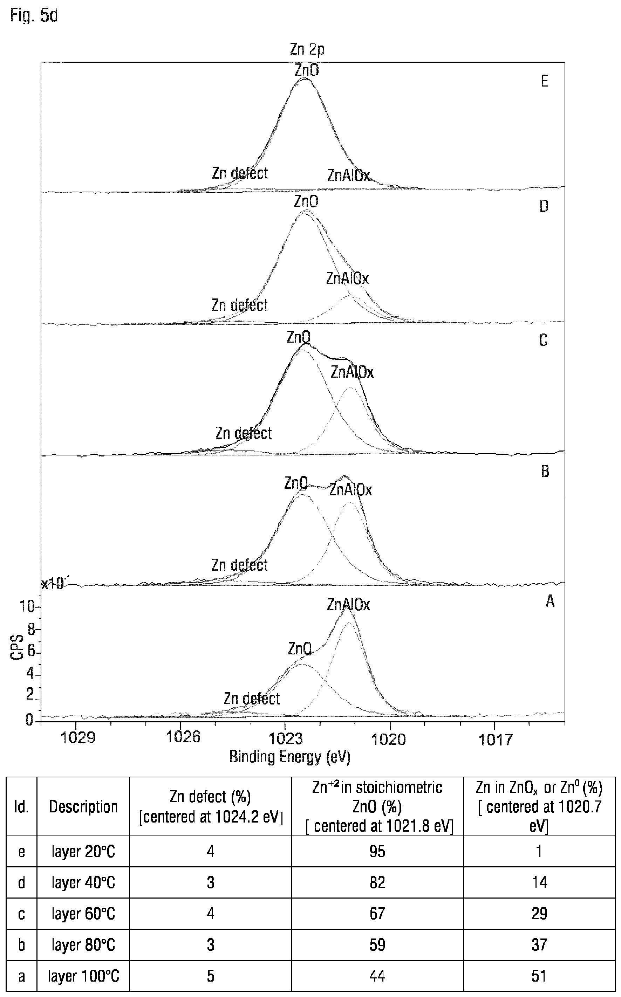

Results shown in figure 5d illustrate the Zn stoichiometry in each layer synthetized at different temperatures with the method of the invention.

Fit of the Zn 2p 3/2 peak is performed with Gaussian centred at different energy values depending on the electronic environment of the Zn element. Quantitative analysis of Zn⁰ compared to Zn⁺² is made. The percentages in the table are determined by the relative areas of each peak. The results show that at temperatures, inferior to 60°C, preferably comprised between 20°C and 60°C, the layers contain more than 60 % of Zn⁺² from stochiometric ZnO. At 20°C, the layer contains more than 90% of Zn⁺². At 80°C, the content of Zn⁺² is approximatively equals to 60%. At temperatures above 80°C the quantity of Zn⁰ is superior to the quantity of Zn⁺² in the layer. The large quantity of Zn⁺² in the layer provides nonconductive properties to the layer which is of interest to produce dielectric product.

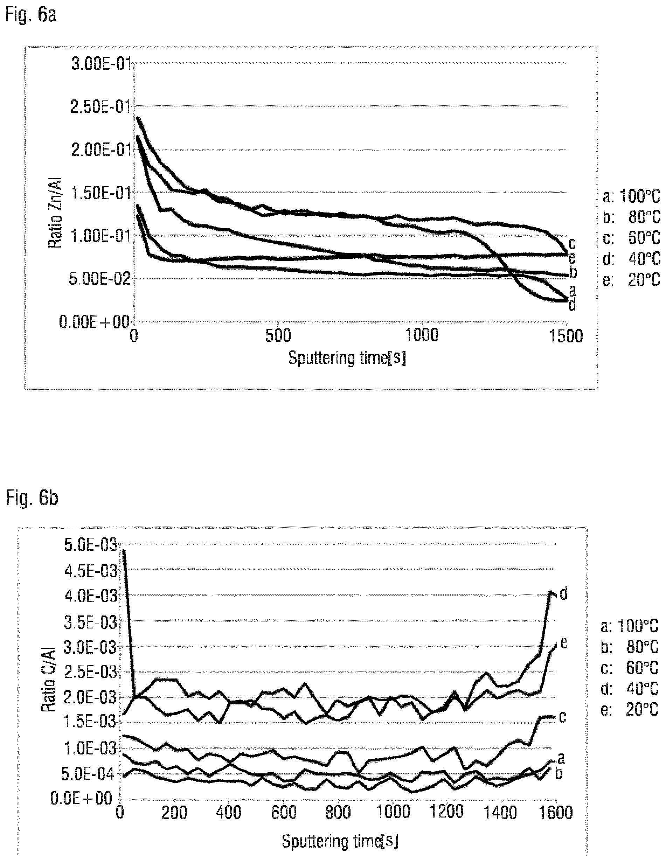

The ratio of Zn/Al was measured by Secondary Ion Mass Spectrometry (SIMS) (figure 6a) in sample formed with the DEZ-TMA-H₂O ALD method at temperatures of 20°C, 40°C, 60°C, 80°C and 100°C. The results show a homogeneous incorporation of Zn according to the sputtering time. Zn is homogeneously incorporated in the layer grown at 20°C with the ALD method according to the invention.

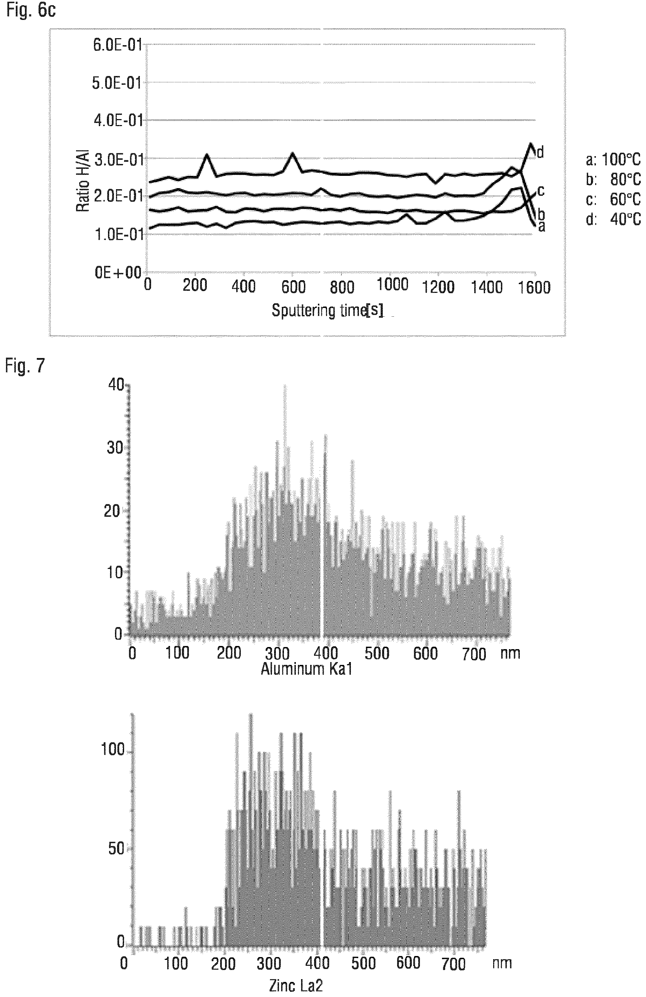

Figure 6b and Figure 6c show respectively the ratio of C/Al and H/Al. The results show that C increases when the temperature decreases because the oxidation reaction is not completed. H increases when the temperature decreases because the synthesis reaction at low temperature (20°C) is not completed. For the understanding of figure 6c, the result obtained at 40°C is not represented.

An Energy-Dispersive X-ray (EDX) analysis (figure 7) was performed on the sample obtained with the DEZ-TMA-H₂O ALD method performed at 20°C. The resolution is inferior to 100 nm. The results show a homogeneous incorporation of Zn in depth and on the surface of the sample thus in depth and on the surface of the layer.

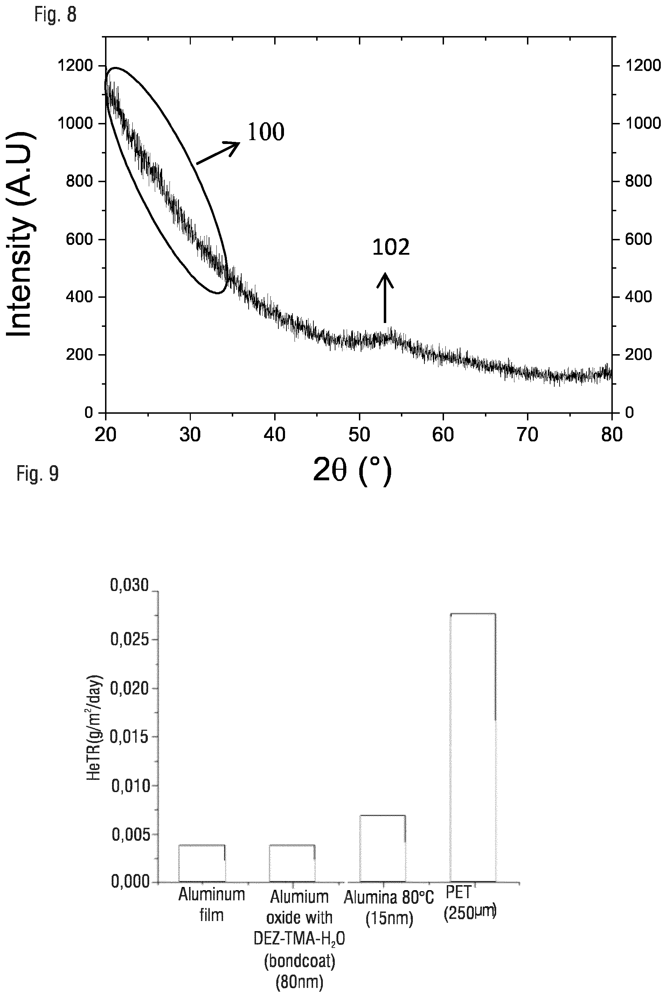

Crystallographic properties were studied by X-Ray Diffraction (XRD) on a sample obtained with the DEZ-TMA-H₂O ALD method at 20°C. The diffractogram (figure 8) of the layer grown with the DEZ-TMA-H₂O ALD method at 20°C shows a signal 100 which corresponds to the substrate signal and a peak 102, which is large and not much intense. This peak 102 is typical for an amorphous sample. The results do not show any trace of crystalline structures which demonstrate the amorphous structure of the layer obtained with the DEZ-TMA-H₂O ALD method.

The dielectric constant was measured on the layer grown with a DEZ-TMA-H₂O ALD method at 20°C with a time of purge of 10 s. The dielectric constant measured is comprised between 5 and 9. These values are in accordance with the dielectric constant of an amorphous Al₂O₃ layer grown by ALD at higher temperature.

The layer of alumina grown with the DEZ-TMA-H₂O ALD method performed at 20°C is optically transparent and presents a refractive index which is comprised between 1.3 and 1.7 at a wavelength of 500 nm. The results are in accordance with the literature values.

The layer has visible light transmittance superior to 80%, more particularly superior to 90%.

The density of the product was also measured. The density of the product is comprised between 2.5 and 4 g.cm⁻³.

The gas permeation rate of the product obtained with the method according to the invention was measured, using helium as reference gas (figure 9). The measured helium permeation rate of the product is below the permeation rate of an optimum alumina thin film (15 nm thick), and reaches the resolution of the measurement apparatus, showing the high gas barrier properties of the new product of the invention.

The layer of aluminium oxide grown with the DEZ-TMA-H₂O ALD method presents the same functional properties as alumina layers grown with ALD at higher temperature in the literature. The method according to the invention can be used to form product or layer based on alumina as dielectric layer, insulating layer, gas permeation layer, encapsulation layer against gas and moisture permeation, corrosion resistant layer or any combination thereof.

The literature data used from this comparative analysis have been take from the following articles:
1) M.D.Groner and al., Chem.Mater. 2004, 16, 639-645
2) M.D.Groner and al.,Thin Solid Films. 2002, 413, 186 - 197
3) K.-H. Choi et al., Chemical Vapor Deposition, 2014, 20, 118-124

## Claims

1. A method for forming doped aluminium oxide on a substrate, said method comprising providing the substrate into a reaction chamber and performing at least one atomic layer deposition cycle, each cycle comprising the sequential steps (6; 8) of:
- exposing the substrate to a trimethylaluminium precursor into the reaction chamber;
- exposing the substrate to an oxidant into the reaction chamber; the method further comprises a step (4) of exposing the substrate to a diethylzinc precursor before the step (6) or at least one of the steps (6) of exposing the substrate to the trimethylaluminum precursor,
**characterized in that** said method is performed at a temperature between 20 °C and 60 °C.

2. Method according to claim 1, **characterized in that** the oxidant is H₂O.

3. Method according to any one of claims 1 and 2, **characterized in that** the step (4) of exposing the substrate to the diethylzinc precursor takes place before each of the steps (6) of exposing the substrate to the trimethylaluminum precursor.

4. Method according to any one of claims 1 and 2, **characterized in that** the step (4) of exposing the substrate to the diethylzinc precursor takes place before the first one of the steps (6) of exposing the substrate to the trimethylaluminum precursor.

5. Method according to any one of claims 1 to 4, **characterized in that** at least one, preferably each, of the steps (4;6;8) of exposing the substrate to the diethylzinc precursor, the trimethylaluminum precursor and to the oxidant is followed by a step of removing, preferably by purge, the excess of the diethylzinc precursor, the trimethylaluminium precursor and/or the oxidant.

6. Method according to any one of claims 1 to 5, **characterized in that** each step (4;6) of exposing the substrate to the diethylzinc precursor and the trimethylaluminum precursor is performed with a carrier gas, said gas preferably being nitrogen or argon.

7. Method according to any one of claims 1 to 6, **characterized in that** said method is performed at a pressure which is comprised between 0 mbar and 1000 mbar, preferably between 1 mbar and 5 mbar.

8. Method according to any one of claims 1 to 7, **characterized in that** the duration of each step (4;6;8) of exposing the substrate to the diethylzinc precursor, the trimethylaluminum precursor and to the oxidant is comprised between 1 µs to 60 s.

9. Method according to any one of claims 5 to 8, **characterized in that** the step of removing the excess is a step of purge, the duration of each step of purge is comprised between 0 s to 600 s.

10. Method according to any one of claims 1 to 9, **characterized in that** the thickness of the layer increases approximately until 134 nm when the method is performed at 20 °C in the presence of water.

11. A product containing a layer of doped aluminium oxide on a substrate said doped aluminium oxide layer being Zn-doped Al₂O₃, **characterized in that** a content of Zn²⁺ is larger than 60 atom% of the whole Zn, consisting of "Zn defect", "Zn²⁺ in stoichiometric ZnO" and "Zn in ZnOx or Zn⁰ or ZnAlOx", present in said product, when said product is obtained by the process according to any one of claims 1-10 performed at temperatures between 20 °C and 60 °C, wherein the content of "Zn defect", "Zn²⁺ in stoichiometric ZnO" and "Zn in ZnOx or Zn⁰ or ZnAlOx" is obtained by X-Ray Photoelectron Spectroscopy.

12. The product according to claim 11, **characterized in that** said doped aluminium oxide layer is amorphous and/or **in that** zinc is homogeneously incorporated therein.

13. The product according to any one of claims 11 to 12, **characterized in that** said doped aluminium oxide layer has a dielectric constant which is comprised between 5 and 9 and/or has a refractive index at a wavelength of 500 nm which is comprised between 1.3 and 1.7.

14. The product according to any one of claims 11 to 13, **characterized in that** said doped aluminium oxide layer is a dielectric and/or optically transparent, having a density comprised between 2.5 g.cm⁻³ and 4 g.cm⁻³.

## Patentansprüche

1. Verfahren zur Bildung von dotiertem Aluminiumoxid auf einem Substrat, wobei das Verfahren das Einbringen des Substrats in eine Reaktionskammer und das Durchführen von mindestens einem Atomlagenabscheidungs-Zyklus umfasst, wobei jeder Zyklus die aufeinanderfolgenden Schritte (6; 8) umfasst:
- Aussetzen des Substrats einem Trimethylaluminium-Präkursor in der Reaktionskammer;
- Aussetzen des Substrats einem Oxidationsmittel in der Reaktionskammer;
wobei das Verfahren ferner einen Schritt (4) des Aussetzens des Substrats einem Diethylzink-Präkursor vor dem Schritt (6) oder vor mindestens einem der Schritte (6) des Aussetzens des Substrats dem Trimethylaluminium-Präkursor umfasst,
**dadurch gekennzeichnet,**
**dass** das Verfahren bei einer Temperatur zwischen 20 °C und 60 °C durchgeführt wird.

2. Verfahren nach Anspruch 1, **dadurch gekennzeichnet, dass** das Oxidationsmittel H₂O ist.

3. Verfahren nach einem der Ansprüche 1 und 2, **dadurch gekennzeichnet, dass** der Schritt (4) des Aussetzens des Substrats dem Diethylzink-Präkursor vor jedem der Schritte (6) des Aussetzens des Substrats dem Trimethylaluminium-Präkursor erfolgt.

4. Verfahren nach einem der Ansprüche 1 und 2, **dadurch gekennzeichnet, dass** der Schritt (4) des Aussetzens des Substrats dem Diethylzink-Präkursor vor dem ersten der Schritte (6) des Aussetzens des Substrats dem Trimethylaluminium-Präkursor erfolgt.

5. Verfahren nach einem der Ansprüche 1 bis 4, **dadurch gekennzeichnet, dass** mindestens einer, vorzugsweise jeder, der Schritte (4; 6; 8) des Aussetzens des Substrats dem Diethylzink-Präkursor, dem Trimethylaluminium-Präkursor und dem Oxidationsmittel von einem Schritt des Entfernens, vorzugsweise durch Spülen, des Überschusses des Diethylzink-Präkursors, des Trimethylaluminium-Präkursors und/oder des Oxidationsmittels gefolgt ist.

6. Verfahren nach einem der Ansprüche 1 bis 5, **dadurch gekennzeichnet, dass** jeder Schritt (4; 6) des Aussetzens des Substrats dem Diethylzink-Präkursor und dem Trimethylaluminium-Präkursor mit einem Trägergas durchgeführt wird, wobei das Gas vorzugsweise Stickstoff oder Argon ist.

7. Verfahren nach einem der Ansprüche 1 bis 6, **dadurch gekennzeichnet, dass** das Verfahren bei einem Druck durchgeführt wird, der zwischen 0 mbar und 1000 mbar liegt, vorzugsweise zwischen 1 mbar und 5 mbar.

8. Verfahren nach einem der Ansprüche 1 bis 7, **dadurch gekennzeichnet, dass** die Dauer jedes Schrittes (4; 6; 8) des Aussetzens des Substrats dem Diethylzink-Präkursor, dem Trimethylaluminium-Präkursor und dem Oxidationsmittel zwischen 1 µs und 60 s liegt.

9. Verfahren nach einem der Ansprüche 5 bis 8, **dadurch gekennzeichnet, dass** der Schritt des Entfernens des Überschusses ein Spülschritt ist, wobei die Dauer jedes Spülschrittes zwischen 0 s und 600 s liegt.

10. Verfahren nach einem der Ansprüche 1 bis 9, **dadurch gekennzeichnet, dass** die Schichtdicke annähernd bis zu 134 nm zunimmt, wenn das Verfahren bei 20 °C in Gegenwart von Wasser durchgeführt wird.

11. Produkt, das eine Schicht aus dotiertem Aluminiumoxid auf einem Substrat enthält, wobei die dotierte Aluminiumoxidschicht Zn-dotiertes Al₂O₃ ist, **dadurch gekennzeichnet, dass** ein Gehalt an Zn²⁺ größer ist als 60 Atom-% des gesamten in dem Produkt vorhandenen Zinks, bestehend aus "Zn-Defekt", "Zn²⁺ in stöchiometrischem ZnO" und "Zn²⁺ in ZnOₓ oder ZnAlOₓ", wenn das Produkt durch das Verfahren nach einem der Ansprüche 1 bis 10, das bei Temperaturen zwischen 20 °C und 60 °C durchgeführt wird, erhalten wird, wobei der Gehalt an "Zn-Defekt", "Zn²⁺ in stöchiometrischem ZnO" und "Zn²⁺ in ZnOₓ oder ZnAlOₓ" mittels Röntgenphotoelektronenspektroskopie bestimmt wird.

12. Produkt nach Anspruch 11, **dadurch gekennzeichnet, dass** die dotierte Aluminiumoxidschicht amorph ist und/oder dass Zink homogen darin eingelagert ist.

13. Produkt nach einem der Ansprüche 11 oder 12, **dadurch gekennzeichnet, dass** die dotierte Aluminiumoxidschicht eine Dielektrizitätskonstante aufweist, die zwischen 5 und 9 liegt, und/oder einen Brechungsindex bei einer Wellenlänge von 500 nm aufweist, der zwischen 1,3 und 1,7 liegt.

14. Produkt nach einem der Ansprüche 11 bis 13, **dadurch gekennzeichnet, dass** die dotierte Aluminiumoxidschicht dielektrisch und/oder optisch transparent ist und eine Dichte zwischen 2,5 g·cm⁻³ und 4 g·cm⁻³ aufweist.

## Revendications

1. Procédé de formation d'un oxyde d'aluminium dopé sur un substrat, ledit procédé comprenant l'introduction du substrat dans une chambre de réaction et la réalisation d'au moins un cycle de dépôt en couches atomiques, chaque cycle comprenant les étapes séquentielles (6; 8) consistant à :
- exposer le substrat à un précurseur de triméthylaluminium dans la chambre de réaction ;
- exposer le substrat à un oxydant dans la chambre de réaction ;
le procédé comprenant en outre une étape (4) consistant à exposer le substrat à un précurseur de diéthylzinc avant l'étape (6) ou au moins une des étapes (6) d'exposition du substrat au précurseur de triméthylaluminium,
**caractérisé en ce que** ledit procédé est réalisé à une température comprise entre 20 °C et 60 °C.

2. Procédé selon la revendication 1, **caractérisé en ce que** l'oxydant est H₂O.

3. Procédé selon l'une quelconque des revendications 1 et 2, **caractérisé en ce que** l'étape (4) d'exposition du substrat au précurseur de diéthylzinc a lieu avant chacune des étapes (6) d'exposition du substrat au précurseur de triméthylaluminium.

4. Procédé selon l'une quelconque des revendications 1 et 2, **caractérisé en ce que** l'étape (4) d'exposition du substrat au précurseur de diéthylzinc a lieu avant la première des étapes (6) d'exposition du substrat au précurseur de triméthylaluminium.

5. Procédé selon l'une quelconque des revendications 1 à 4, **caractérisé en ce qu'**au moins une, de préférence chacune, des étapes (4; 6; 8) d'exposition du substrat au précurseur de diéthylzinc, au précurseur de triméthylaluminium et à l'oxydant est suivie d'une étape d'élimination, de préférence par purge, de l'excès du précurseur de diéthylzinc, du précurseur de triméthylaluminium et/ou de l'oxydant.

6. Procédé selon l'une quelconque des revendications 1 à 5, **caractérisé en ce que** chaque étape (4; 6) d'exposition du substrat au précurseur de diéthylzinc et au précurseur de triméthylaluminium est réalisée avec un gaz vecteur, ledit gaz étant de préférence de l'azote ou de l'argon.

7. Procédé selon l'une quelconque des revendications 1 à 6, **caractérisé en ce que** ledit procédé est réalisé à une pression comprise entre 0 mbar et 1000 mbar, de préférence entre 1 mbar et 5 mbar.

8. Procédé selon l'une quelconque des revendications 1 à 7, **caractérisé en ce que** la durée de chaque étape (4; 6; 8) d'exposition du substrat au précurseur de diéthylzinc, au précurseur de triméthylaluminium et à l'oxydant est comprise entre 1 µs et 60 s.

9. Procédé selon l'une quelconque des revendications 5 à 8, **caractérisé en ce que** l'étape d'élimination de l'excès est une étape de purge, la durée de chaque étape de purge étant comprise entre 0 s et 600 s.

10. Procédé selon l'une quelconque des revendications 1 à 9, **caractérisé en ce que** l'épaisseur de la couche augmente approximativement jusqu'à 134 nm lorsque le procédé est réalisé à 20 °C en présence d'eau.

11. Produit contenant une couche d'oxyde d'aluminium dopé sur un substrat, ladite couche d'oxyde d'aluminium dopé étant un Al₂O₃ dopé au Zn, **caractérisé en ce que** une teneur en Zn²⁺ est supérieure à 60 atomes % de l'ensemble du Zn, constitué de « défaut de Zn », de « Zn2+ dans ZnO stœchiométrique » et de « Zn²⁺ dans ZnOₓ ou Zn⁰ ou ZnAlOx », présent dans ledit produit, lorsque ledit produit est obtenu par le procédé selon l'une quelconque des revendications 1 à 10 réalisé à des températures comprises entre 20 °C et 60 °C, la teneur en « défaut de Zn », « Zn²⁺ dans ZnO stœchiométrique » et « Zn²⁺ dans ZnOₓ ou Zn0 ou ZnAlOₓ » étant obtenue par spectroscopie de photoélectrons X.

12. Produit selon la revendication 11, **caractérisé en ce que** ladite couche d'oxyde d'aluminium dopé est amorphe et/ou **en ce que** le zinc y est incorporé de manière homogène.

13. Produit selon l'une quelconque des revendications 11 ou 12, **caractérisé en ce que** ladite couche d'oxyde d'aluminium dopé a une constante diélectrique comprise entre 5 et 9 et/ou a un indice de réfraction, à une longueur d'onde de 500 nm, compris entre 1,3 et 1,7.

14. Produit selon l'une quelconque des revendications 11 à 13, **caractérisé en ce que** ladite couche d'oxyde d'aluminium dopé est diélectrique et/ou optiquement transparente, ayant une densité comprise entre 2,5 g.cm⁻³ et 4 g.cm⁻³.
